# EUROPEAN PATENT SPECIFICATION

(11) **EP 0 488 632 B1**
(45) Date of publication and mention of the grant of the patent: **12.02.1997**
(21) Application number: 91310852.8
(22) Date of filing: 26.11.1991
(51) Int. Cl.: H01L 21/20, H01L 33/00

(54) **A method for growing a compound semiconductor and a method for producing a semiconductor laser**
Verfahren zum Aufwachsen eines Verbundhalbleiters und Verfahren zur Herstellung eines Halbleiterlaser
Méthode pour la croissance d'un alliage semi-conducteur et méthode pour fabriquer un laser à semi-conducteur

(30) Priority: 26.11.1990 JP 324347/90
(43) Date of publication of application: 03.06.1992
(73) Proprietor: SHARP KABUSHIKI KAISHA, Osaka 545 (JP)
(72) Inventor: Seki, Akinori, Toyota-shi, Aichi-ken (JP); Hosoba, Hiroyuki, Shiki-gun, Nara-ken (JP); Hata, Toshio, Nara-shi, Nara-ken (JP); Kondo, Masafumi, Nara-shi, Nara-ken (JP); Suyama, Takahiro, 1-106, Koriyama -, Yamatokoriyama-shi, Nara-ken (JP); Matsui, Sadayoshi, Tenri-shi, Nara-ken (JP)
(74) Representative: White, Martin David

(56) References cited:
- EP-A- 0 196 897
- EP-A- 0 456 485
- PATENT ABSTRACTS OF JAPAN vol. 10, no. 306 (E-446)17 October 1986
- PATENT ABSTRACTS OF JAPAN vol. 14, no. 89 (E-891)19 February 1990

## Description

### BACKGROUND OF THE INVENTION

### 1. Field of the Invention:

The present invention relates to a method for growing GaAs and AlGaAs layers by the use of an MBE device, and more particularly to a method for producing an AlGaAs system semiconductor laser by the use of the MBE device.

### 2. Description of the Prior Art:

In recent years, a method for producing high electron mobility transistor (HEMTs) and semiconductor lasers as an AlGaAs system semiconductor device by the use of an MBE device has been proposed. These devices function by epitaxially growing an AlGaAs layer and a GaAs layer on a GaAs substrate.

In the epitaxial growth used for producing an AlGaAs system device by the MBE device, cleanliness and unevenness of the substrate surface has a great influence on the quality of the epitaxial layer. In order to make a GaAs surface clean, the surface of the GaAs substrate is oxidized by H₂SO₄ type etching or is heated, followed by evaporation of an oxidizing layer in the MBE device under the conditions of ultra vacuum and an atmosphere of arsenic gas. In order to provide the substrate with a flat surface, a GaAs buffer layer with a thickness of several µm is grown on the substrate at a relatively low temperature of 500 to 550°C. However, in some cases it is required that a satisfactory AlₓGa₁₋ₓAs layer be directly formed onto, the substrate due to the element structure (such as layer thickness and layer structure) of the semiconductor device. Moreover, when a GaAs buffer layer with a poor crystallinity caused by defects or impurities on the growing field on the substrate has an adverse effect on the characteristics of the device, for example when an active region (a channel region **41**) of an HEMT shown in Figure **4** is disposed close to a buffer layer **40** and the characteristics of the buffer layer **40** have such an influence on those of the HEMT as a reduced mobility of channel electrons caused by scattering impurities, it is required that a satisfactory GaAs buffer layer is directly formed on the substrate.

A typical method for producing a semiconductor laser by the use of the MBE device is disclosed in Japanese Patent Publication No. 1-37873. In this method, a semiconductor substrate is taken out of the MBE device after a first growing layer is formed in the first growing step. Then, a striped groove with a predetermined width and a depth which reaches a GaAs light absorption layer of the first growing layer is formed in the photolithography and etching step. In this step, impurities such as oxide adhere to the etched portion, i.e., the surface of the light absorption layer. These impurities are evaporated by thermal cleaning with irradiating arsenic (As). Then, a second growing layer is formed in the second growing step by the use of the MBE.

According to the above method for producing semiconductor lasers, a very clean upper surface of a clad layer can be obtained by evaporating these impurities as well as the GaAs light absorption layer in the active region. Then, a growing layer of high quality containing no impurities can be obtained in the second growing step by the use of the MBE.

However, in the above cleaning step by the thermal etching using only As, the surface condition in cleaning is greatly influenced by the cleanliness of the surface of the etched portion, intensity of irradiation of As, the temperature of the heat treatment and the difference in level of the first growing layer formed by etching. Therefore, very limiting conditions are required to be set in order to get a surface having good quality and satisfactory flatness. Particularly, the dispersion of the cleanliness of the etched surface leads to the dispersion of the evaporation rate of the surface. As a result, the etched GaAs layer partially remains and a flat thermal cleaning surface with high repeatability cannot be obtained. The microscopic unevenness caused after etching the substrate is enlarged by thermal etching thereafter. In addition, since the evaporation rate greatly depends upon the temperature or arsenic pressure on the substrate, there arises a dispersion in the evaporation rate when a dispersion exists in the temperature or arsenic pressure, and it is difficult to obtain a flat evaporation surface. Because of these phenomena, a part of the etched portion (GaAs layer) remains between the first growing layer (the clad layer of the AlₓGa₁₋ₓAs layer) and the second growing layer (the clad layer of the AlₓGa₁₋ₓAs layer in the above-mentioned semiconductor laser structure, thereby having adverse effects on the laser oscillation characteristics (i.e., decreasing luminous efficiency). Accordingly, there arise problems of yield and/or lack of uniformity.

EP-A-0 196 897 discloses a process for thermally etching a GaAs substrate before molecular beam epitaxy. The process comprises the step of heating the GaAs substrate to above 750°C, at which temperature both Ga and As are evaporated from the GaAs substrate, while irradiating it with an As beam, thereby removing contamination adhering to the surface of the GaAs substrate.

### Summary of the Invention

According to the present invention there is provided a method of growing a Ga₁₋ₓAlₓAs (0 ≤ x ≤ 1) layer on a substrate, the method comprising: a first growing step of growing a GaAs layer on a substrate; a first cleaning step of cleaning the surface of the GaAs layer by heating the substrate to a first temperature and irradiating the substrate with an arsenic molecular beam; a second cleaning step of heating the substrate to a second temperature higher than the first temperature and simultaneously irradiating the GaAs layer with gallium and arsenic molecular beams, the conditions being chosen so that the growth rate of the GaAs layer is lower than the evaporation rate of the GaAs layer during the second cleaning step; and a second growing step of growing the Ga₁₋ₓAlₓAs (0 ≤ x ≤ 1) layer by molecular beam epitaxy.

In a preferred embodiment the first growing step comprises growing a first layered structure which includes the GaAs layer; the method further comprises an etching step of partially etching the first layered structure to expose the GaAs layer, the etching step being carried out before the second cleaning step; and the second growing step comprises growing a second layered structure which includes the Ga₁₋ₓAlₓAs (0 ≤ x ≤ 1) layer.

In an alternative preferred embodiment the substrate is a semi-insulating GaAs substrate and the AlₓGa₁₋ₓAs (0 ≤ x ≤ 1) layer is a GaAs layer including a channel region for a high electron mobility transistor.

In a preferred embodiment an upper layer of the substrate is an AlₓGa₁₋ₓAs (0 ≤ x ≤ 1) layer.

In a preferred embodiment the first temperature is in the range 620 to 650° and the second temperature is in the range of 720 to 760°C.

According to the present invention, in the epitaxial growth method and the method for producing a semiconductor laser, before the compound semiconductor made of the AlₓGa₁₋ₓAs (0 ≦ x ≦ 1) layer is formed on the semiconductor substrate whose surface is a GaAs layer, the substrate is maintained at a high temperature in the range of 600 to 800°C with the simultaneous irradiation of the Ga molecular beam and the As molecular beam. In this way, the GaAs layer is deposited and the surface of the semiconductor substrate is made flat. Moreover, the thermal etching of the GaAs layer is effected, whereby a flat and clean etched surface can be realized. As described above, the present invention comprises the simultaneous irradiation of the Ga molecular beam and the As molecular beam, and the heat treatment process at high temperatures in which the GaAs layer can be evaporated.

Thus, the invention described herein makes possible the objectives of (1) providing an epitaxial growth method enabling a construction in which an AlGaAs layer is directly deposited on a semiconductor (AlGaAs system) substrate or in which a GaAs buffer layer having poor crystalline characteristics is not included; and (2) providing a method for producing a semiconductor laser in which a partially remained portion of the etched surface caused by the dispersion of precision of thermal etching conditions and by the dispersion of photolithography and etching and unevenness caused by this portion can be eliminated and a flat thermal etching surface can be formed, thereby realizing satisfactory semiconductor laser characteristics.

### BRIEF DESCRIPTION OF THE DRAWINGS

This invention may be better understood and its numerous objects and advantages will become apparent to those skilled in the art by reference to the accompanying drawings as follows:

Figures **1(a)** and **1(b)** are schematic sectional views illustrating an embodiment of the epitaxial growth method according to the present invention.

Figures **2(a)** to **2(d)** are schematic sectional views illustrating an embodiment of a method for producing an electron device (HEMT or the like) according to the present invention.

Figures **3(a)** to **3(d)** are schematic sectional views illustrating an embodiment of a method for producing a semiconductor laser according to the present invention.

Figure **4** is a schematic sectional view illustrating a method for producing a conventional electron device (HEMT).

### DESCRIPTION OF THE PREFERRED EMBODIMENTS

The present invention will be described by way of illustrating embodiments with reference to the drawings below.

### (Epitaxial growth method)

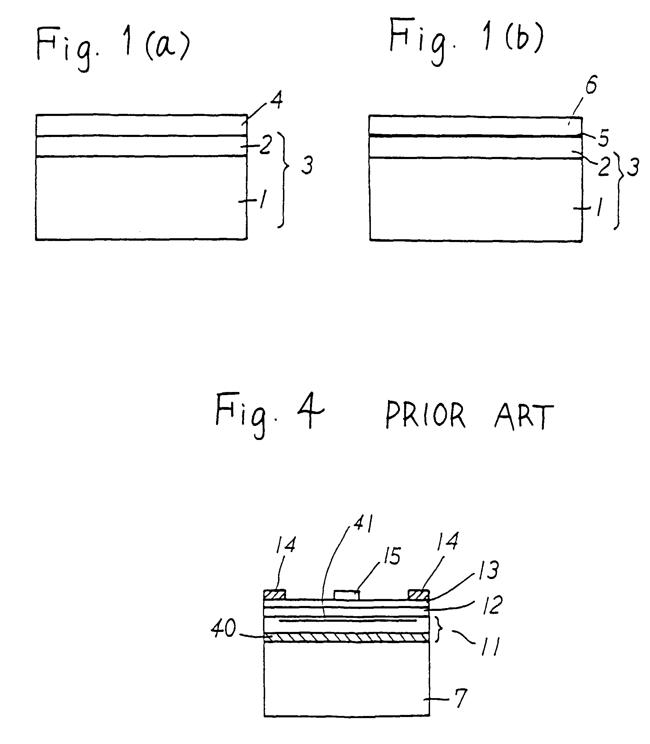

Figures **1(a)** and **1(b)** are sectional views illustrating an embodiment of an epitaxial growth method according to the present invention. A compound semiconductor substrate **3** (consisting of an AlₓGa₁₋ₓAs layer **2** and a GaAs substrate **1**) on which a GaAs layer **4** with a thickness of several hundred nanometres has been previously deposited by an epitaxial growth method such as the MBE method or the MOCVD method is placed in an MBE apparatus. The compound semiconductor substrate **3** is heated to a desired temperature (about 630°C) while being irradiated with an As molecular beam so that the oxidizing layer of the surface of the GaAs layer **4** is removed by evaporation (see Figure **1(a)**). Then, the compound semiconductor substrate **3** is heated with a simultaneous irradiation of a predetermined amount of the Ga (gallium) molecular beam and the As molecular beam, and is maintained at a temperature in the range of 720 to 760°C for about thirty minutes while forming a first GaAs layer (a layer for evaporation). At this time, the amount of the incident molecular beams of Ga is kept so as to make the growth rate of GaAs layer lower than the evaporation rate thereof. In this way, the GaAs layer is evaporated (i.e., thermal etching is effected), and a flat and clean interface **5** is obtained. Moreover, an AlGaAs layer **6** is deposited by irradiating an Al (aluminum) molecular beam successively. As a result, a satisfactory flat epitaxial layer of the AlGaAs layer **6** which is directly deposited on the compound semiconductor substrate **3** with no buffer layer formed therebetween (see Figure **1(b)**).

### (Electron device)

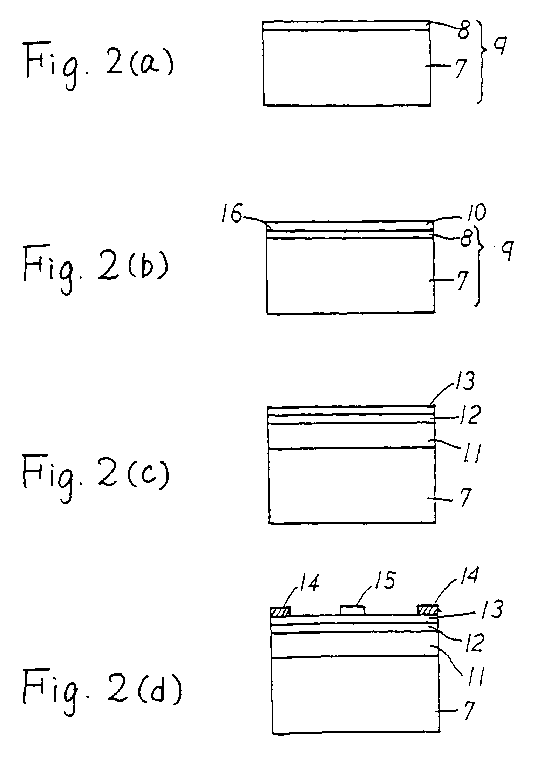

Figures **2(a)** to **2(d)** are sectional views illustrating an embodiment of a method for producing an electron device (HEMT) according to the present invention.

Figure **2(a)** shows a semi-insulating GaAs substrate **9** (consisting of a first GaAs layer for evaporation **8** and a layer which is not evaporated **7**) used for the MBE growth, the surface of which is cleaned by a predetermined etching treatment. The GaAs substrate 9 is placed in the MBE device, heated to a desired temperature in the range of 620 to 650°C while being irradiated with the As molecular beam, and a natural oxide film adhered to the surface of the GaAs substrate **9** is evaporated, thereby obtaining a clean GaAs surface.

Then, the resulting GaAs substrate **9** is heated to a temperature of 720 to 750°C with simultaneous irradiation of a predetermined amount of the Ga molecular beam and the As molecular beam, and a growing interface **16** and the first GaAs layer for evaporation **8** (the upper portion of the semi-insulating GaAs substrate **9**) are evaporated while a second GaAs layer for evaporation **10** is formed (see Figure **2(b)**).

In this way, the first and the second GaAs layers for evaporation **8** and **10** are removed by evaporation, thereby obtaining a very flat clean surface of the substrate. An undoped GaAs layer **11**, an N-type Al_{0.3}Ga_{0.7}As layer **12** and an N-type GaAs layer **13** are successively formed with a predetermined growth temperature (about 500°C) kept on the substrate (see Figure **2(c)**). The thus obtained HEMT structure substrate is taken out of the MBE device. An AuGe/Ni/Au N-type Ohmic electrode **14** and a Ti/Pt/Au P-type Schottky electrode are formed on the substrate by vacuum evaporation as shown in Figure **2(d)**. In this way, an HEMT structure with a clear and flat growing interface on the substrate can be produced.

### (Method for producing a semiconductor laser)

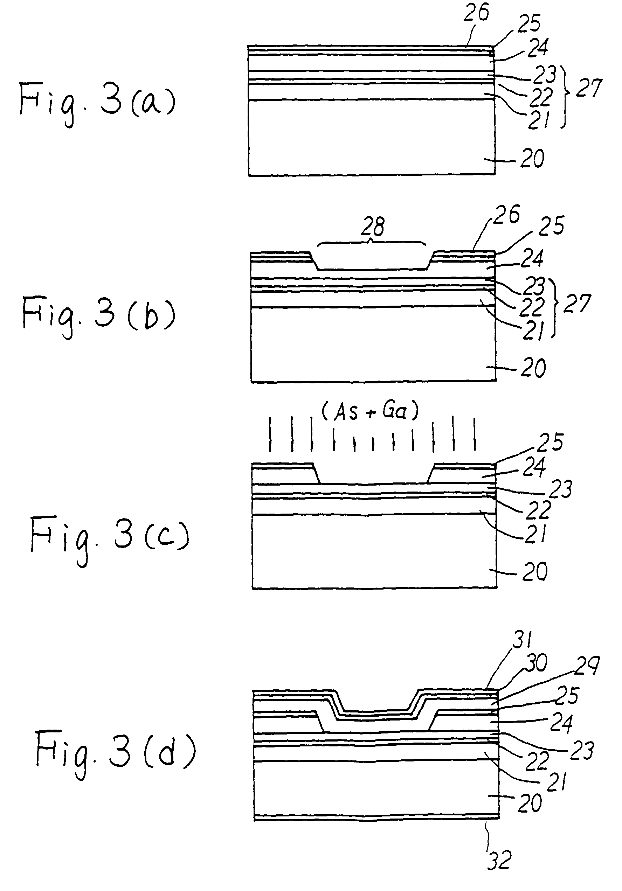

Figures **3(a)** to **3(d)** show an embodiment of a method for producing a semiconductor laser according to the present invention.

A light absorption layer **24** made of GaAs, an evaporation-preventing layer 25 made of an AlGaAs layer, a regrowth protection layer **26** made of GaAs and a Double Hetero (DH) structure **27** made of AlGaAs layers are epitaxially grown on an N-type (100) GaAs substrate **20** by the epitaxial growth method such as the MBE method and the MOCVD method (see Figure **3(a)**). The compound semiconductor substrate on which the above DH structure is grown is temporarily taken out of the growing device, a stripe-shaped groove (having a width of 3 to 5 µm) is formed in a region which is to be a current passage **28** by predetermined photolithography and etching steps, leaving the GaAs light absorption layer **24** of 100 nm thickness (see Figure **3(b)**). Then, the compound semiconductor substrate with this striped-shaped groove is again placed in the MBE device and the As molecular beam is irradiated until a predetermined temperature (620 to 650°C) is obtained. Furthermore, while a predetermined amount of the Ga molecular beam is irradiated together with the As molecular beam, the temperature of the substrate is kept at a temperature in the range of 720 to 760°C for several ten of minutes. The amount of the Ga molecular beam at this time is set so that the evaporation rate of the GaAs is higher than the growth rate thereof. Accordingly, on the surface of the compound semiconductor substrate, a GaAs layer is deposited and evaporated at the same time, resulting in evaporating the exposed GaAs layer and exposing a clear AlGaAs layer as shown in Figure **3(c)**. The exposed AlGaAs layer includes a first AlGaAs clad layer **23** in the current passage **28** and the evaporation-preventing layer **25** made of AlGaAs on the other region.

A second AlGaAs clad layer **29** and a GaAs cap layer **30** are successively formed by combined irradiation of the Al molecular beam and Be molecular beam. Then the substrate is taken out of the MBE device, and a semiconductor laser structure is produced by forming a P-type electrode **31** and an N-type electrode **32** by vacuum evaporation.

As described above, according to the epitaxial growth method of the present invention, the thermal etching is effected at a high temperature (600 to 800°C) while the Ga molecular beam and the As molecular beam are simultaneously irradiated. The etched surface is made flat owing to the GaAs layer formed by the above simultaneous irradiation, and the GaAs buffer layer and the layer in which impurities remain are removed by the thermal etching at a high temperature. Accordingly, in the present example, a satisfactory flat thermal etching surface, in which there is no GaAs buffer layer or unevenness of the layer having impurities and the etched surface, or unevenness caused by the dispersion of the thermal etching conditions, can be obtained.

It is understood that various other modifications will be apparent to and can be readily made by those skilled in the art without departing from the scope of this invention as defined by the appended claims.

## Claims

1. A method of growing a Ga₁₋ₓAlₓAs (0 ≤ x ≤ 1) layer (6, 11, 29) on a substrate (3, 7, 20), the method comprising:
a first growing step of growing a GaAs layer (4, 8, 24) on a substrate (3, 7, 20);
a first cleaning step of cleaning the surface of the GaAs layer (4, 8, 24) by heating the substrate (3, 7, 20) to a first temperature and irradiating the substrate (3, 7, 20) with an arsenic molecular beam;
a second cleaning step by heating the substrate (3, 7, 20) to a second temperature higher than the first temperature and simultaneously irradiating the GaAs layer (4, 8, 24) with gallium and arsenic molecular beams, the conditions being chosen so that the growth rate of the GaAs layer (4, 8, 24) is lower than the evaporation rate of the GaAs layer (4, 8, 24) during the second cleaning step; and
a second growing step of growing the Ga₁₋ₓAlₓAs (0 ≤ x ≤ 1) layer (6, 11, 29) by molecular beam epitaxy.

2. A method as claimed in claim 1, wherein the first growing step comprises growing a first layered structure which includes the GaAs layer (24);
wherein the method further comprises an etching step of partially etching the first layered structure to expose the GaAs layer (24), the etching step being carried out before the second cleaning step; and
wherein the second growing step comprises growing a second layered structure which includes the Ga₁₋ₓAlₓAs (0 ≤ x ≤ 1) layer (29).

3. A method according to claim 1, wherein the substrate is a semi-insulating GaAs substrate and the AlₓGa₁₋ₓAs (0 ≤ x ≤ 1) layer is a GaAs layer including a channel region for a high electron mobility transistor.

4. A method according to claim 1 wherein an upper layer of the substrate (3) is an AlₓGa₁₋ₓAs (0 ≤ x ≤ 1) layer (2).

5. A method according to any preceding claim, wherein the first temperature is in the range 620 to 650° and the second temperature is in the range of 720 to 760°C.

## Patentansprüche

1. Verfahren zum Aufwachsen einer Ga₁₋ₓAlₓAs(0 ≤ x ≤ 1)-Schicht (6, 11, 29) auf ein Substrat (3, 7, 20), wobei das Verfahren folgendes umfaßt:
- einen ersten Aufwachsschritt des Aufwachsens einer GaAs-Schicht (4, 8, 24) auf ein Substrat (3, 7, 20);
- einen ersten Reinigungsschritt des Reinigens der Oberfläche der GaAs-Schicht (4, 8, 24) durch Erwärmen des Substrats (3, 7, 20) auf eine erste Temperatur und durch Bestrahlen des Substrats (3, 7, 20) mit einem Molekülstrahl aus Arsen;
- einen zweiten Reinigungsschritt des Erwärmens des Substrats (3, 7, 20) auf eine zweite Temperatur über der ersten Temperatur und des gleichzeitigen Bestrahlens der GaAs-Schicht (4, 8, 24) mit Molekülstrahlen aus Gallium und Arsen, wobei die Bedingungen so gewählt sind, daß während des zweiten Reinigungsschritts die Aufwachsrate der GaAs-Schicht (4, 8, 24) kleiner als die Verdampfungsrate der GaAs-Schicht (4, 8, 24) ist, und
- einen zweiten Aufwachsschritt des Aufwachsens der Ga₁₋ₓAlₓAs(0 ≤ x ≤ 1)-Schicht (6, 11, 29) durch Molekularstrahlepitaxie.

2. Verfahren nach Anspruch 1,
- bei dem der erste Aufwachsschritt das Aufwachsen einer ersten Schichtstruktur, die die GaAs-Schicht (24) enthält, umfaßt;
- wobei das Verfahren ferner einen Ätzschritt des teilweisen Ätzens der ersten Schichtstruktur zum Freilegen der GaAs-Schicht (24) umfaßt, wobei der Ätzschritt vor dem zweiten Reinigungsschritt ausgeführt wird; und
- wobei der zweite Aufwachsschritt das Aufwachsen einer zweiten Schichtstruktur umfaßt, die die Ga₁₋ₓAlₓAs(0 ≤ x ≤ 1)-Schicht (29) enthält.

3. Verfahren nach Anspruch 1, bei dem das Substrat ein halbisolierendes GaAs-Substrat ist und die AlₓGa₁₋ₓAs(0 ≤ x ≤ 1)-Schicht eine GaAs-Schicht mit einem Kanalbereich für einen Transistor mit hoher Elektronenbeweglichkeit ist.

4. Verfahren nach Anspruch 1, bei dem die obere Schicht des Substrats (3) eine AlₓGa₁₋ₓAs(0 ≤ x ≤ 1)-Schicht (2) ist.

5. Verfahren nach einem der vorstehenden Ansprüche, bei dem die erste Temperatur im Bereich von 620 bis 650° und die zweite Temperatur im Bereich von 720 bis 760°C liegt.

## Revendications

1. Procédé pour la croissance d'une couche (6, 11, 29) en Ga₁₋ₓAlₓAs (0 ≤ x ≤ 1) sur un substrat (3, 7, 20), le procédé comportant:
une première étape de croissance, consistant à faire croître une couche (4, 8, 24) en GaAs sur un substrat (3, 7, 20);
une première étape de nettoyage, consistant à nettoyer la surface de la couche (4, 8, 24) en GaAs en chauffant le substrat (3, 7, 20) à une première température et en irradiant le substrat (3, 7, 20) avec un faisceau moléculaire d'arsenic;
une seconde étape de nettoyage, par chauffage du substrat (3, 7, 20) à une seconde température, supérieure à la première température, et irradiation simultanée de la couche (4, 8, 24) en GaAs avec des faisceaux moléculaires de gallium et d'arsenic, les conditions étant choisies de telle sorte que le taux de croissance de la couche (4, 8, 24) en GaAs soit inférieur au taux d'évaporation de la couche (4, 8, 24) en GaAs pendant la seconde étape de nettoyage; et
une seconde étape de croissance, consistant à faire croître la couche (6, 11, 29) en Ga₁₋ₓAlₓAs (0 ≤ x ≤ 1) par épitaxie par faisceau moléculaire.

2. Procédé selon la revendication 1, dans lequel la première étape de croissance comprend la croissance d'une première couche stratifiée qui comprend la couche (24) en GaAs;
dans lequel le procédé comporte en outre une étape de gravure, consistant à graver partiellement la première structure stratifiée, pour mettre à nu la couche (24) en GaAs, l'étape de gravure étant exécutée avant la seconde étape de nettoyage; et
dans lequel la seconde étape de croissance comprend la croissance d'une seconde structure stratifiée qui comprend la couche (29) en Ga₁₋ₓAlₓAs (0 ≤ x ≤ 1).

3. Procédé selon la revendication 1, dans lequel le substrat est un substrat semi-isolant en GaAs, et la couche de AlₓGa₁₋ₓAs (0 ≤ x ≤ 1) est une couche en GaAs comprenant une région de canal pour un transistor à haute mobilité des électrons.

4. Procédé selon la revendication 1, dans lequel une couche supérieure du substrat (3) est une couche (2) de AlₓGa₁₋ₓAs (0 ≤ x ≤ 1).

5. Procédé selon l'une quelconque des revendications précédentes, dans lequel la première température est dans la plage de 620 à 650° et la seconde température est dans la plage de 720 à 760°C.
